# FASCICULE DE BREVET EUROPEEN

(11) **EP 3 726 731 B1**
(45) Date de publication et mention de la délivrance du brevet: **06.09.2023**
(21) Numéro de dépôt: 20167660.8
(22) Date de dépôt: 02.04.2020
(51) Int. Cl.: H03K 17/12, H03K 17/16

(54) **CIRCUIT DE COMMANDE DE TRANSISTORS**
STEUERSCHALTKREIS VON TRANSISTOREN
TRANSISTOR CONTROL CIRCUIT

(30) Priorité: 05.04.2019 FR 1903689
(43) Date de publication de la demande: 21.10.2020
(73) Titulaire: STMicroelectronics (Rousset) SAS, 13790 Rousset (FR)
(72) Inventeur: BIENVENU, Philippe, 83470 Saint-Maximin (FR)
(74) Mandataire: Cabinet Beaumont

(56) Documents cités:
- DE-A1-102016 121 854
- US-A- 5 949 273
- US-A1- 2004 252 430
- US-A1- 2006 250 742
- US-A1- 2014 062 536
- US-A1- 2018 145 672

## Description

### Domaine technique

La présente description concerne de façon générale les circuits électroniques, et plus particulièrement un circuit de commande de transistors.

### Technique antérieure

Dans certaines applications, on utilise un transistor pour commuter un courant dans une charge et/ou une tension aux bornes de la charge. Un tel transistor est par exemple à effet de champ, par exemple de type MOS. Un circuit de commande de transistor est utilisé pour appliquer un signal de commande à une borne de commande du transistor, telle que la grille du transistor à effet de champ.

Le document US 2014/062536 décrit un module de sortie et un procédé pour commander le module de sortie.

Le document US 2018/145672 décrit un appareil de commande pour interrupteurs.

Le document US 2004/252430 décrit un dispositif semiconducteur de puissance.

Le document DE 10 2016 121854 décrit un circuit de commutation.

### Résumé de l'invention

Il existe un besoin d'améliorer les procédés et circuits connus de commande de transistor, notamment lors d'un changement de l'état passant/non-passant du transistor, plus particulièrement lorsque la charge est inductive.

Un mode de réalisation pallie tout ou partie des inconvénients des circuits connus de commande de transistor.

Un mode de réalisation prévoit de limiter les risques de surchauffe d'un transistor lors d'un changement de l'état passant/non passant du transistor.

Un mode de réalisation prévoit un procédé selon la revendication indépendante 1.

Un mode de réalisation prévoit un circuit selon la revendication indépendante 2.

Selon un mode de réalisation, dans la phase de commande simultanée, l'état passant/non passant d'au moins l'un desdits transistors est fonction seulement du premier signal.

Selon un mode de réalisation, des interrupteurs sont reliés chacun à une borne de commande de l'un desdits transistors et sont commandés par les deuxièmes signaux.

Selon un mode de réalisation, des premières bornes de conduction des transistors sont reliées ensemble aux interrupteurs par une première diode.

Selon un mode de réalisation, la première diode est une diode Zener.

Selon un mode de réalisation, la première diode est électriquement en série avec une deuxième diode.

Selon un mode de réalisation, lesdits interrupteurs relient la première diode aux bornes de commande respectives desdits transistors.

Selon un mode de réalisation, pour chacun desdits transistors, ledit interrupteur relie la borne de commande à une deuxième borne de conduction du transistor et est relié à la première diode par un élément résistif.

Selon un mode de réalisation, chacun desdits interrupteurs est électriquement en parallèle avec une diode supplémentaire, de préférence une diode Zener.

Selon un mode de réalisation, des interrupteurs supplémentaires sont commandés par le premier signal et sont chacun relié à une des bornes de commande desdits transistors.

Un mode de réalisation prévoit un dispositif configuré pour mettre en oeuvre un procédé tel que défini ci-dessus, ou comprenant un circuit tel que défini ci-dessus.

Selon un mode de réalisation, lesdits transistors sont électriquement en parallèle entre un noeud d'application d'un potentiel d'alimentation et un élément inductif.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente, de manière schématique, un mode de réalisation d'un dispositif de commutation d'une charge ;
la figure 2 est un chronogramme représentant schématiquement, en fonction du temps, un exemple de fonctionnement du dispositif de la figure 1 ;
la figure 3 représente schématiquement un exemple de réalisation d'un circuit du dispositif de la figure 1 ;
la figure 4 représente schématiquement une variante de réalisation d'un circuit de commande d'un transistor en fonction d'un signal de commande ; et
la figure 5 représente schématiquement une autre variante de réalisation d'un circuit de commande d'un transistor en fonction d'un signal de commande.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, un circuit de mise à l'état passant d'un transistor lorsqu'un signal reçu par le circuit a un niveau donné, par exemple un niveau haut, n'est pas décrit en détail, les modes de réalisation décrits étant compatibles avec un tel circuit usuel. En outre, les structures des transistors, en particulier les structures de transistors constitués par plusieurs transistors en parallèles, ne sont pas détaillées les modes de réalisation décrits étant compatibles avec de tels transistors usuels.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

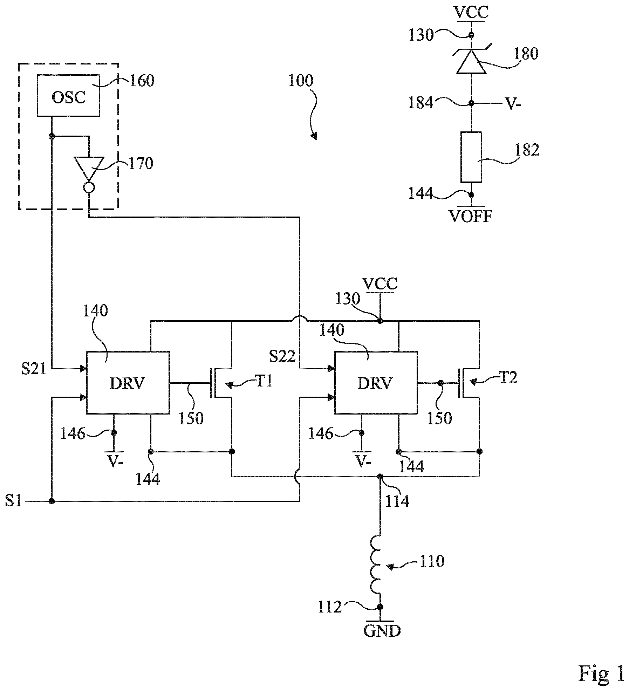

La figure 1 représente, de manière schématique, un mode de réalisation d'un dispositif 100 de commutation d'une charge 110. Dans ce mode de réalisation, la charge 110 est un élément inductif.

Le dispositif 100 permet d'appliquer à des bornes 112 et 114 de la charge 110 une tension d'alimentation, par exemple référencée à la masse GND, en fonction du niveau d'un signal S1. La tension d'alimentation est fournie au dispositif 100 entre un noeud 130 d'application d'un potentiel d'alimentation VCC et la borne 112 de la charge, la borne 112 constituant par exemple un noeud d'application d'un potentiel de référence. Le dispositif 100 est utilisé typiquement dans des applications telles que des applications automobiles, dans lesquelles la tension d'alimentation correspond à celle d'une batterie. La charge est alors par exemple comprise dans un équipement tel que par exemple un convertisseur d'énergie électrique ou un moteur électrique. La tension d'alimentation est typiquement comprise entre 10 V et 100 V, par exemple de l'ordre de 12 V ou de l'ordre de 48 V.

Le dispositif 100 comprend deux transistors T1 et T2. De préférence, les transistors T1 et T2 sont électriquement en parallèle entre la borne 114 de la charge 110 et le noeud 130 d'application du potentiel VCC. L'association en parallèle des transistors T1 et T2 est ainsi en série avec la charge entre les noeuds 130 et 112 d'application de la tension d'alimentation. Les transistors T1 et T2 sont de préférence des transistors à effet de champ, par exemple de type MOS. Chaque transistor T1, T2 peut être constitué de plusieurs transistors électriquement en parallèle dont les bornes de commande sont connectées entre elles. De préférence, les transistors T1 et T2 sont à canal N, et le potentiel VCC est positif. En variante, les transistors T1 et T2 sont à canal P, et le potentiel VCC est négatif.

Les transistors T1 et T2 sont commandés simultanément, c'est-à-dire ensemble, en fonction du signal de commande S1. Autrement dit, le signal de commande S1 est le même signal pour les transistors T1 et T2. Pour cela, pour chaque transistor T1, T2, le dispositif 100 comprend un circuit 140 (DRV) de commande de la grille 150 du transistor en fonction du signal S1. Les circuits 140 reçoivent le même signal S1 et sont chacun relié, de préférence connecté, à la grille 150 du transistor T1, T2 concerné.

Chaque circuit est configuré pour fournir un potentiel VON. L'application du potentiel VON à la grille 150 du transistors T1, T2 concerné met ce transistor à l'état passant. Chaque circuit 140 est relié, de préférence connecté, à un noeud 144 d'application d'un potentiel VOFF. L'application du potentiel VOFF à la grille 150 d'un des transistors T1, T2 met ce transistor à l'état non passant.

Dans l'exemple représenté, chaque circuit 140 est relié, de préférence connecté, au noeud 130 d'application du potentiel VCC. De préférence, le potentiel VON est supérieur à celui du drain du transistor. De préférence, le potentiel VON est généré par chaque circuit 140 à partir du potentiel VCC par une pompe de charge. En variante, le potentiel VON est fourni aux circuits 140, par exemple par un circuit commun non représenté. Le potentiel VON associé à chaque transistor T1, T2 peut être tout potentiel apte à rendre le transistor passant lorsqu'il est appliqué à la grille du transistor.

Dans l'exemple représenté, le noeud 144 de chaque circuit 140 est relié, de préférence connecté, à la source du transistor T1, T2 concerné. Le potentiel VOFF est donc ici celui de la source du transistor. Cet exemple n'est pas limitatif, et le potentiel VOFF associé à chaque transistor T1, T2 peut être tout potentiel apte à rendre le transistor non passant lorsqu'il est appliqué à la grille du transistor.

Dans le présent mode de réalisation, chaque circuit 140 est en outre relié à un noeud 146 d'application d'un potentiel V-. Le potentiel V- est appliqué aux grilles des transistors par les circuits 140 en fonction de signaux de commande S21 et S22 reçus par les circuits 140 associés aux transistors respectifs T1 et T2. Les transistors T1 et T2 sont commandés de manière dissociée, c'est-à-dire individuellement ou séparément, les signaux S21 et S22 étant distincts pour les deux transistors. Les signaux S21 et S22 sont répétitifs en créneaux, c'est-à-dire qu'ils comprennent une alternance répétée d'un niveau logique bas et d'un niveau logique haut. De préférence, les niveaux bas et haut sont répétés régulièrement. De préférence, la durée des créneaux est proche de celle entre les créneaux, par exemple ces durées sont égales.

Les signaux S21 et S22 sont opposés, c'est-à-dire que chacun des signaux S21 et S22 est à l'état logique haut lorsque l'autre des signaux S21 et S22 est à l'état logique bas. De préférence, le signal S21 est fourni par un oscillateur 160 (OSC). La sortie de l'oscillateur 160 est alors, de préférence, reliée, par exemple connectée, à l'entrée d'un inverseur 170. L'inverseur 170 reçoit le signal S21 et fournit le signal S22.

Chaque circuit 140 est configuré pour appliquer le potentiel VON sur la grille 150 lorsque le signal S1, ou premier signal, est au niveau logique haut. Lorsque le premier signal S1 est au niveau logique bas, chaque circuit 140 applique sur la grille 150 :
- si le deuxième signal S21, S22 est au niveau haut, le potentiel V- ; et
- si le deuxième signal S21, S22 est au niveau bas, le potentiel VOFF.

De préférence, le potentiel V- est fourni par une diode Zener 180 et un élément résistif 182 en série entre le noeud 130 d'application du potentiel VCC et le noeud 144 d'application du potentiel VOFF. Le potentiel V- est alors fourni sur le noeud 184 qui connecte la diode 180 et l'élément résistif 182 en série. Le noeud 184 est relié, de préférence connecté, au noeud 146 (connexion non représentée). Dans le cas d'un potentiel VCC positif, la cathode de la diode 180 est reliée, de préférence connectée, au noeud 130 d'application du potentiel VCC. Dans le cas préféré de transistors en parallèle entre le noeud 130 et la borne 114 de la charge 110, la diode Zener 180 et le potentiel V- peuvent être communs pour les transistors T1 et T2.

Le potentiel V- ainsi obtenu est strictement compris entre les potentiels des bornes de conduction des transistors. De préférence, la différence entre les potentiels VCC et V-est supérieure, en valeur absolue, à la tension d'alimentation appliquée entre le noeud 130 et la masse. Ainsi, pour un potentiel d'alimentation VCC positif, le potentiel V-, référencé par rapport à la masse, est négatif. De plus, le potentiel V- est généré et appliqué au noeud 146 uniquement lorsque la tension entre les bornes de conduction du transistor est supérieure au seuil de la diode Zener 180.

A la place de la diode 180 et de l'élément résistif 182, on peut utiliser tout circuit permettant de générer et d'appliquer le potentiel V- au noeud 146, lorsque la tension entre les bornes de conduction du transistor est supérieure à un seuil.

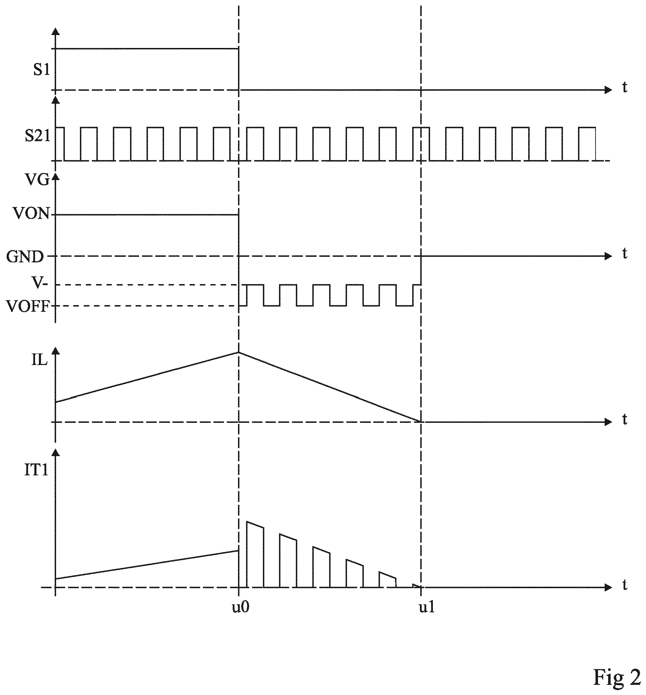

La figure 2 est un chronogramme représentant schématiquement en fonction du temps t, dans un exemple de fonctionnement du dispositif 100 de la figure 1, le signal S21, la tension VG de la grille 150 du transistor T1, le courant IL dans la charge 110, et le courant IT1 dans le transistor T1.

Dans cet exemple, le signal S1 est au niveau haut avant un instant u0 et au niveau bas après l'instant u0.

Dans une phase de fonctionnement, c'est-à-dire une étape du procédé mis en oeuvre par le dispositif 100, avant l'instant u0, le potentiel VON est appliqué aux grilles 150 des transistors T1 et T2, quel que soit le niveau des deuxièmes signaux S21 et S22. Les transistors sont à l'état passant. Le courant IL dans la charge 110 augmente. Le courant dans chaque transistor T1, T2 correspond à une partie du courant IL. Par exemple, les transistors T1 et T2 sont identiques, et le courant dans chacun des transistors T1 et T2 est égal à la moitié du courant IL.

Une autre phase de fonctionnement est mise en oeuvre après l'instant u0. Au cours de cette phase, lorsque le signal S21 est au niveau haut, le potentiel V- est appliqué à la grille du transistor T1, et le potentiel VOFF est appliqué à celle du transistor T2. Similairement, lorsque le signal S21 est au niveau bas, le potentiel V- est appliqué à la grille du transistor T2 et le potentiel VOFF est appliqué à la grille du transistor T1. La différence entre les potentiels V- et VOFF permet, pour chaque transistor T1, T2, de laisser passer le courant IL dans le transistor lorsque le potentiel V- est appliqué à sa grille. Du fait de la présence du courant IL dans la charge inductive 110, le potentiel VOFF de la borne 114 de la charge a une valeur plus négative que le potentiel négatif V-. Ceci provoque une diminution du courant IL dans la charge 110. Le courant IL s'annule à un instant u1.

Ainsi, l'application du potentiel V- alternativement sur la grille du transistor T1 et sur la grille du transistor T2 permet, après le passage du signal S1 à l'état bas, de réduire le courant IL dans la charge 110, par exemple jusqu'à l'annulation du courant IL.

De préférence, après l'instant u0, lorsque le signal S21 passe au niveau bas, le potentiel V- est d'abord appliqué à la grille du transistor T2, puis le potentiel VOFF est appliqué à la grille du transistor T1. De même, lorsque le signal S21 passe du niveau haut au niveau bas, le potentiel V- est appliqué à la grille du transistor T1 puis le potentiel VOFF est appliqué à la grille du transistor T2. On évite ainsi que les deux transistors T1 et T2 soient non passants simultanément.

Pour réduire le courant dans la charge, on aurait pu penser utiliser, en série avec la charge, un seul transistor remplaçant les transistors T1 et T2, par exemple un transistor de taille deux fois plus élevée que la taille des transistors T1 et T2. Après passage du signal S1 à l'état logique bas, on aurait alors appliqué le potentiel V- à la grille du transistor pour annuler le courant dans la charge. Cependant, le passage dans le transistor du courant circulant dans la charge aurait risqué de provoquer une instabilité thermique dans le transistor. Une telle instabilité thermique peut se produire lorsque la tension entre les bornes de conduction du transistor est élevée, par exemple supérieure à 10 V, voire supérieure à 100 V. L'instabilité thermique peut se produire lorsque le transistor est soumis à une densité de courant élevée, par exemple supérieure à 1 A/mm². L'instabilité thermique consiste en l'apparition de points chauds dans le transistor, susceptibles d'endommager ou de détruire le transistor sans laisser le temps ou la possibilité à des moyens de protection de détecter une surchauffe du transistor.

Dans le dispositif 100, entre les instants u0 et u1, lorsque le signal S21 est au niveau haut, la totalité du courant circulant dans la charge passe par le transistor T1. Lorsque le signal S21 est au niveau bas, aucun courant ne passe dans le transistor T1. De même, le courant dans le transistor T2 alterne entre la valeur nulle et la valeur du courant dans la charge 110. Les inventeurs ont remarqué que, pour chaque transistor T1 ou T2 soumis alternativement à un courant nul et au courant circulant dans la charge, le risque d'instabilité thermique est plus réduit que si ce transistor était soumis de manière continue à la moitié du courant circulant dans la charge. De préférence, la durée de chacun des créneaux des signaux S21 et S22 est inférieure au temps mis par une instabilité thermique pour se développer dans le transistor. On évite alors le risque d'instabilité thermique. Pour cela, la fréquence des signaux S21 et S22 est par exemple supérieure à 5 kHz, de préférence comprise entre 5 kHz et 20 kHz.

Dans une autre phase après l'instant u1, le courant dans la charge 110 est nul, et le potentiel de la borne 114 est nul. Dans l'exemple représenté, le potentiel V- n'est plus appliqué aux grilles 150 des transistors T1 et T2. Dans cet exemple, le potentiel V- n'est pas généré en l'absence de courant dans la charge 110. Dans cette phase, l'état passant/non passant des transistors ne dépend alors que du signal S1, comme avant l'instant u0.

Bien que l'on ait décrit ci-dessus un mode particulier de génération de la tension V-, tout générateur usuel peut être utilisé. Par exemple, le potentiel V- peut continuer à être généré et appliqué aux grilles des transistors après l'instant u1, ceci laissant les transistors à l'état non passant. En variante, le potentiel V- est généré dans chaque circuit 140, par exemple chaque circuit 140 comprend une diode Zener en série avec un élément résistif entre les bornes de conduction du transistor concerné, et le potentiel V- est celui du noeud de connexion entre la diode Zener et l'élément résistif.

Bien que l'on ait décrit ci-dessus un mode de réalisation comprenant deux transistors T1 et T2, d'autres modes de réalisation comprennent plus de deux transistors Ti. La grille, ou la borne de commande, de chaque transistor Ti est reliée à un circuit 140. Les circuits 140 reçoivent le même signal S1, et reçoivent des signaux S2i en créneaux déphasés les uns par rapport aux autres. De préférence, les phases des signaux S2i sont réparties uniformément entre 0 et 360 degrés. Lorsque le signal S1 est au niveau haut, chaque circuit 140 applique le potentiel VON sur la grille 150. Lorsque le premier signal S1 est au niveau bas, chaque circuit 140 applique sur la grille 150 :
- si le deuxième signal S2i reçu par le circuit 140 est au niveau haut, le potentiel V- ; et
- si le deuxième signal S2i reçu par le circuit 140 est au niveau bas, le potentiel VOFF.

Dans une application telle que l'alimentation d'une charge inductive, les transistors Ti sont alors électriquement en parallèle, et l'association en parallèle des transistors est en série avec la charge entre des noeuds d'application de la tension d'alimentation. De préférence, les signaux Si ne sont jamais simultanément au niveau bas.

Dans les modes de réalisation décrits, dans chacun des signaux S1 et S2i, les niveaux logiques haut et bas peuvent être remplacés par n'importe quel couple de premier et deuxième niveaux différents. De préférence, les premiers et deuxième niveaux logiques sont les mêmes pour tous les signaux S2i. De plus, un fonctionnement similaire à celui décrit ci-dessus peut être obtenu en échangeant les signes des potentiels et les types de conductivité N et P des transistors.

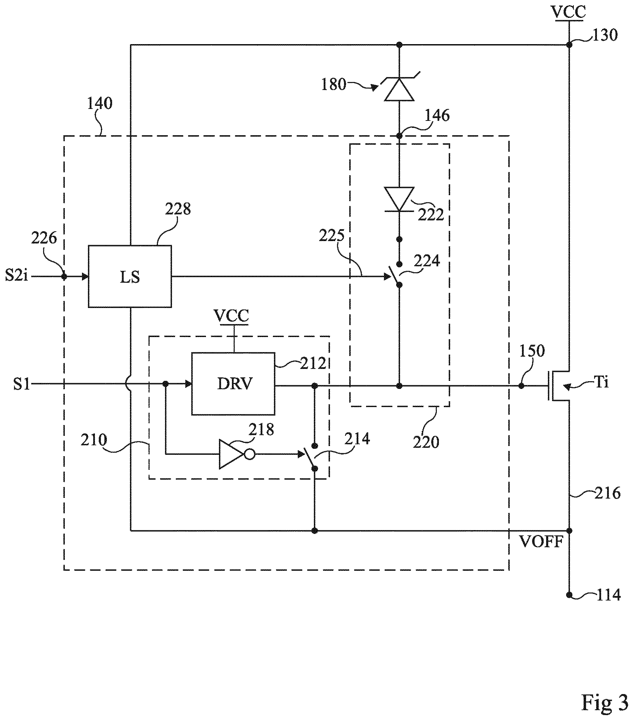

La figure 3 représente schématiquement un exemple de réalisation de l'un des circuits 140 du dispositif de la figure 1, relié à la diode Zener 180 et commandant la grille 150 d'un transistor Ti.

Le circuit 140 comprend un circuit 210 de commande du transistor Ti en fonction du signal S1. Le circuit 210 comprend en particulier un circuit 212 (DRV) d'application de la tension VON à la grille 150 du transistor Ti lorsque le signal S1 est à un premier niveau, par exemple un niveau haut. Le circuit 210 comprend en outre un interrupteur 214 reliant la grille 150 au noeud d'application du potentiel VOFF, ici une borne de conduction 216 du transistor Ti. La borne 216 est par exemple reliée, de préférence connectée, à la borne 114 de la charge 110 (figure 1). L'interrupteur 214 est commandé par la sortie d'un inverseur 218 qui reçoit sur son entrée le signal S1. De préférence, l'interrupteur 214 est un transistor à effet de champ, par exemple de type MOS.

Le circuit 140 comprend en outre un circuit 220 de commande du transistor T1 en fonction du signal S2i. Dans cet exemple, le circuit 220 comprend une diode 222 et un interrupteur 224 reliés en série, de préférence connectés en série, entre le noeud 146 et la grille 150. De préférence, l'anode de la diode 222 est connectée au noeud 146. De préférence, l'interrupteur 224 est un transistor à effet de champ, par exemple de type MOS. Une borne de commande 225 de l'interrupteur 224 est reliée à un noeud 226 d'entrée du signal S2i. Dans cet exemple, le noeud 226 et la borne de commande 225 sont reliés entre eux par un circuit de mise à niveau (LS) 228. Le circuit 228 permet d'appliquer à la borne de commande 225 des niveaux de tension permettant de mettre l'interrupteur 224 à l'état passant lorsque le signal S2i est à un premier niveau, et à l'état non passant lorsque le signal S2i est à un deuxième niveau. A titre d'exemple, le circuit 228 applique sur la borne 225 le potentiel VCC lorsque le signal S2i est à l'état logique haut, et le potentiel VOFF lorsque le signal S2i est à l'état logique bas.

Dans l'exemple représenté, la diode Zener 180 et le noeud 146 sont communs à tous les circuits 140. La diode 222 peut être commune à tous les circuits 140 ou peut être distincte dans chaque circuit 140.

Dans une variante, le circuit 228 est omis, et la borne de commande 225 et le noeud d'entrée 226 sont connectés entre eux. Les niveaux du signal S2i sont choisis pour mettre l'interrupteur 224 respectivement à l'état passant et à l'état non passant lorsque le signal S2i est appliqué directement à la borne 225. Pour cela, le circuit générateur du signal S2i (oscillateur 160, figure 1) peut alors comprendre un circuit de mise à niveau.

En fonctionnement, dans une phase où le signal S1 est à un premier niveau, par exemple le niveau haut, les interrupteurs 214 de tous les circuits 140 sont à l'état non passant, et les circuits 212 mettent les transistors Ti à l'état passant.

Dans une autre phase où le signal S1 est à un deuxième niveau, par exemple le niveau bas, les interrupteurs 214 de tous les circuits 140 sont à l'état passant, et les circuits 212 n'appliquent par exemple aucun potentiel aux grilles 150 des transistors Ti. Dans cette phase, lorsque le signal S2i est à un premier niveau, l'interrupteur 224 concerné est à l'état non passant. Ainsi, le potentiel VOFF est appliqué à la grille 150 du transistor Ti concerné. Dans cette phase, lorsque le signal S2i est à un deuxième niveau, les interrupteurs 214 et 224 sont à l'état passant. Les résistances des interrupteurs 214 et 224 à l'état passant sont choisies pour que le potentiel appliqué à la grille 150 soit alors le potentiel V- prédéfini. Pour cela, on pourra prévoir un élément résistif en série avec l'un et/ou l'autre des interrupteurs 224 et 214. L'élément résistif 182 (figure 1) peut être omis, et son rôle joué par les interrupteurs 224 et 214.

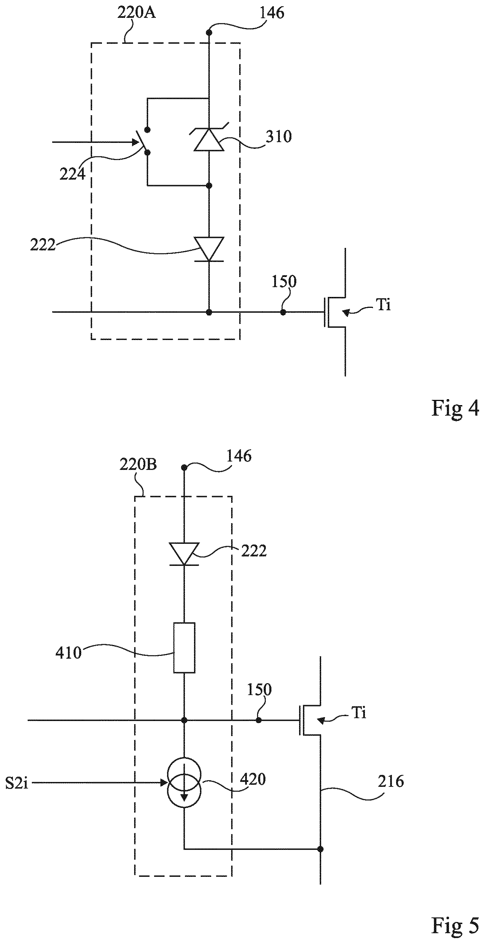

La figure 4 représente schématiquement une variante de réalisation d'un circuit 220A de commande du transistor Ti en fonction du signal S2i. Le circuit 220A peut remplacer le circuit 220 dans le circuit 140 de la figure 3. Le circuit 220A comprend des éléments communs avec le circuit 220 de la figure 3, et seules les différences entre les circuits 220A et 220 sont mises ici en exergue.

Le circuit 220A diffère du circuit 220 de la figure 3 en ce que les positions des interrupteurs 224 et de la diode 222 ont été échangées, et en ce que le circuit 220A comprend en outre une diode Zener 310 en parallèle de l'interrupteur 224. La diode 222 a sa cathode reliée, de préférence connectée, à la grille 150, et son anode reliée, de préférence connectée, à celle de la diode Zener 310. La diode Zener 310 a sa cathode reliée au noeud 146.

La figure 5 représente schématiquement une autre variante de réalisation d'un circuit 220B de commande du transistor Ti en fonction du signal S2i. Le circuit 220B peut remplacer le circuit 220 dans le circuit 140 de la figure 3.

Le circuit 220B comprend la diode 222 et un élément résistif 410 reliés en série, de préférence connectés en série, entre le noeud 146 et la grille 150. A titre d'exemple, l'anode de la diode 222 est connectée au noeud 146, et l'élément résistif 410 est connecté à la grille 150. Le circuit 220B comprend en outre une source de courant 420 commandée par le signal S2i. La source de courant 420 relie la grille 150 à la borne de conduction 216 du transistor Ti.

En fonctionnement, lorsque le signal S2i est à un premier niveau, la source 420 prélève un courant sur la grille 150. La valeur du courant prélevé et de la résistance de l'élément 410 sont choisis pour que la grille 150 se trouve alors à un potentiel qui rend le transistor Ti à l'état non passant (potentiel VOFF). Lorsque le signal S2i est à un deuxième niveau, la source 420 ne prélève pas de courant sur le noeud 150. On choisit la résistance de l'élément 410 et de l'interrupteur 214 (figure 3) de sorte que le potentiel de la grille corresponde alors au potentiel V- prédéfini. De préférence, la source de courant 420 comprend, par exemple est constituée par, un interrupteur reliant la grille 150 à la borne de conduction 216 du transistor Ti, par exemple la source 420 est un transistor à effet de champ, par exemple de type MOS.

Divers modes de réalisation et variantes ont été décrits. L'homme de l'art comprendra que certaines caractéristiques de ces divers modes de réalisation et variantes pourraient être combinées, et d'autres variantes apparaîtront à l'homme de l'art.

Enfin, la mise en oeuvre pratique des modes de réalisation et variantes décrits est à la portée de l'homme du métier à partir des indications fonctionnelles données ci-dessus.

## Revendications

1. Procédé comprenant :
- quand un premier signal (S1) est dans un état logique haut, une phase de commande simultanée de plusieurs transistors (Ti) en parallèle, en appliquant sur les grilles desdits transistors un potentiel (VON) rendant passant lesdits transistors ; et
- quand le premier signal est dans un état logique bas et qu'une tension entre bornes de commande (150) et de conduction (130) desdits transistors (Ti) est supérieure à un seuil, une phase de commande dissociée desdits transistors par des deuxièmes signaux (S2i) opposés, répétés en créneaux, un état logique bas de chaque deuxième signal rendant non passant le transistor (Ti) commandé par ce deuxième signal et un état logique haut de chaque deuxième signal provoquant l'application, sur la grille du transistor (Ti) concerné, d'un potentiel (V-) strictement compris entre les potentiels des bornes de conduction (130, 216) du transistor.

2. Circuit comportant :
- plusieurs transistors (Ti) en parallèle ; et
- un circuit de commande configuré pour :
quand un premier signal (S1) est dans un état logique haut, mettre en oeuvre une phase de commande simultanée des transistors (Ti) en appliquant sur les grilles desdits transistors un potentiel (VON) rendant passant lesdits transistors ; et
- quand le premier signal est dans un état logique bas et qu'une tension entre bornes de commande (150) et de conduction (130) desdits transistors (Ti) est supérieure à un seuil, une phase de commande dissociée desdits transistors par des deuxièmes signaux (S2i) opposés, répétés en créneaux, un état logique bas de chaque deuxième signal rendant non passant le transistor (Ti) concerné et un état logique haut de chaque deuxième signal provoquant l'application, sur la grille du transistor (Ti) concerné, d'un potentiel (V-) strictement compris entre les potentiels des bornes de conduction (130, 216) du transistor.

3. Procédé selon la revendication 1 ou circuit selon la revendication 2, dans lequel, dans la phase de commande simultanée, l'état passant/non passant d'au moins l'un desdits transistors (Ti) est fonction seulement du premier signal (S1).

4. Procédé selon la revendication 1 ou 3 ou circuit selon la revendication 2 ou 3, dans lequel des interrupteurs (224 ; 420) sont reliés chacun à une borne de commande (150) de l'un desdits transistors (Ti) et sont commandés par les deuxièmes signaux (S2i).

5. Procédé ou circuit selon la revendication 4, dans lequel des premières bornes de conduction (130) des transistors (Ti) sont reliées ensemble aux interrupteurs (224 ; 420) par une première diode (180).

6. Procédé ou circuit selon la revendication 5, dans lequel la première diode (180) est une diode Zener.

7. Procédé ou circuit selon la revendication 5 ou 6, dans lequel la première diode (180) est électriquement en série avec une deuxième diode (222).

8. Procédé ou circuit selon l'une quelconque des revendications 5 à 7, dans lequel lesdits interrupteurs (224) relient la première diode (180) aux bornes de commande (150) respectives desdits transistors.

9. Procédé ou circuit selon l'une quelconque des revendications 5 à 7, dans lequel, pour chacun desdits transistors (Ti), ledit interrupteur (420) relie la borne de commande (150) à une deuxième borne de conduction (216) du transistor et est relié à la première diode (180) par un élément résistif (410).

10. Procédé ou circuit selon l'une quelconque des revendications 5 à 9, dans lequel chacun desdits interrupteurs (224) est électriquement en parallèle avec une diode supplémentaire (310), de préférence une diode Zener.

11. Procédé ou circuit selon l'une quelconque des revendications 5 à 10, dans lequel des interrupteurs supplémentaires (214) sont commandés par le premier signal (S1) et sont chacun relié à une des bornes de commande (150) desdits transistors (Ti).

12. Dispositif configuré pour mettre en oeuvre un procédé selon l'une quelconque des revendications 1 et 3 à 11, ou comprenant un circuit selon l'une quelconque des revendications 2 à 11.

13. Dispositif selon la revendication 12, dans lequel lesdits transistors (Ti) sont électriquement en parallèle entre un noeud (130) d'application d'un potentiel d'alimentation (VCC) et un élément inductif (110).

## Patentansprüche

1. Verfahren, das Folgendes aufweist:
- wenn ein erstes Signal (S1) auf einem hohen logischen Pegel ist, eine Phase gleichzeitiger Steuerung von mehreren parallelen Transistoren (Ti) und zwar durch Anlegen eines Potentials (VON) an die Gates der Transistoren, das die Transistoren einschaltet; und
- wenn das erste Signal auf einem niedrigen logischen Pegel ist und wenn eine Spannung über Steuer- (150) und Leitungsanschlüsse (130) der Transistoren (Ti) höher als ein Schwellenwert ist, eine Phase getrennter Steuerung der Transistoren und zwar durch entgegengesetzte zweite Signale (S2i), die in Schlitzen wiederholt werden, wobei ein niedriger logischer Zustand jedes zweiten Signals den Transistor (Ti) sperrt, der durch das zweite Signal gesteuert wird, und ein hoher logischer Zustand jedes zweiten Signals das Anlegen, an das Gate des betreffenden Transistors (Ti), eines Potentials (V-) bewirkt, das streng zwischen den Potentialen der Leitungsanschlüsse (130, 216) des Transistors liegt.

2. Schaltung, die Folgendes aufweist:
- mehrere Transistoren (Ti) in Parallelschaltung; und
- eine Steuerschaltung, die eingerichtet ist zum:
Implementieren, wenn ein erstes Signal (S1) auf einem hohen logischen Pegel ist, einer Phase gleichzeitiger Steuerung der Transistoren (Ti) durch Anlegen eines Potentials (VON) an die Gates der Transistoren, das die Transistoren einschaltet; und
- Implementieren, wenn das erste Signal auf einem niedrigen logischen Pegel ist und wenn eine Spannung über Steuer- (150) und Leitungsanschlüsse (130) der Transistoren höher als ein Schwellenwert ist, einer Phase getrennter Steuerung der Transistoren durch entgegengesetzte zweite Signale (S2i), die in Schlitzen wiederholt werden, wobei ein niedriger logischer Zustand jedes zweiten Signals den betreffenden Transistor (Ti) sperrt und ein hoher logischer Zustand jedes zweiten Signals das Anlegen, an das Gate des betreffenden Transistors (Ti), eines Potentials (V-) bewirkt, das streng zwischen den Potentialen der Leitungsanschlüsse (130, 216) des Transistors liegt.

3. Verfahren nach Anspruch 1 oder Schaltung nach Anspruch 2, wobei, in der Phase gleichzeitiger Steuerung, der Ein-/Aus-Zustand von mindestens einem der Transistoren (Ti) eine Funktion von ausschließlich dem ersten Signal (S1) ist.

4. Verfahren nach Anspruch 1 oder 3 oder Schaltung nach Anspruch 2 oder 3, wobei Schalter (224; 420) jeweils mit einem Steueranschluss (150) eines der Transistoren (Ti) gekoppelt sind und durch die zweiten Signale (S2i) gesteuert werden.

5. Verfahren oder Schaltung nach Anspruch 4, wobei erste Leitungsanschlüsse (130) der Transistoren (Ti) mit den Schaltern (224; 420) durch eine erste Diode (180) zusammen gekoppelt sind.

6. Verfahren oder Schaltung nach Anspruch 5, wobei die erste Diode (180) eine Zener-Diode ist.

7. Verfahren oder Schaltung nach Anspruch 5 oder 6, wobei die erste Diode (180) elektrisch in Reihe mit einer zweiten Diode (222) geschaltet ist.

8. Verfahren oder Schaltung nach einem der Ansprüche 5 bis 7, wobei die Schalter (224) die erste Diode (180) mit entsprechenden Steueranschlüssen (150) der Transistoren koppeln.

9. Verfahren oder Schaltung nach einem der Ansprüche 5 bis 7, wobei für jeden der Transistoren (Ti), der Schalter (420) den Steueranschluss (150) mit einem zweiten Leitungsanschluss (216) des Transistors koppelt und mit der ersten Diode (180) über ein Widerstandselement (410) gekoppelt ist.

10. Verfahren oder Schaltung nach einem der Ansprüche 5 bis 9, wobei jeder der Schalter (224) elektrisch parallel zu einer zusätzlichen Diode (310) geschaltet ist, vorzugsweise einer Zener-Diode.

11. Verfahren oder Schaltung nach einem der Ansprüche 5 bis 10, wobei zusätzliche Schalter (214) durch das erste Signal (S1) gesteuert werden und jeweils mit einem der Steueranschlüsse (150) der Transistoren (Ti) gekoppelt sind.

12. Vorrichtung, die zum Implementieren eines Verfahrens nach einem der Ansprüche 1 und 3 bis 11 eingerichtet ist oder eine Schaltung nach einem der Ansprüche 2 bis 11 aufweist.

13. Vorrichtung nach Anspruch 12, wobei die Transistoren (Ti) elektrisch parallel zwischen einem Knoten (130) zum Anlegen eines Leistungsversorgungspotentials (VCC) und einem induktiven Element (110) geschaltet sind.

## Claims

1. Method comprising:
- when a first signal (S1) is at a high logic level, a phase of simultaneous control of several parallel transistors (Ti), by applying on the gates of said transistors a potential (VON) turning said transistors on; and
- when the first signal is at a low logic level, and a voltage across control (150) and conduction (130) terminals of said transistors (Ti)is higher than a threshold, a dissociated control phase of said transistors by opposed second signals (S2i) repeated in slots, a low logic state of each second signal turning the transistor (Ti) controlled by this second signal off, and a high logic state of each second signal causing the application, on the gate of the concerned transistor (Ti), of a potential (V-) strictly comprised between the potentials of the conduction terminals (130, 216) of the transistor.

2. Circuit including:
- several transistors (Ti) in parallel; and
- a control circuit configured to:
when a first signal (S1) is at a high logic level, implementing a phase of simultaneous control of the transistors (Ti) by applying on the gates of said transistors a potential (VON) turning said transistors on; and
- when the first signal is at a low logic level, and a voltage across control (150) and conduction (130) terminals of said transistors is higher than a threshold, implementing a dissociated control phase of said transistors by opposed second signals (S2i) repeated in slots, a low logic state of each second signal turning the concerned transistor (Ti) off, and a high logic state of each second signal causing the application, on the gate of the concerned transistor (Ti), of a potential (V-) strictly comprised between the potentials of the conduction terminals (130, 216) of the transistor.

3. Method according to claim 1, or circuit according to claim 2, wherein, in the phase of simultaneous control, the on/off state of at least one of said transistors (Ti) is a function only of the first signal (S1).

4. Method according to claim 1 or 3 or circuit according to claim 2 or 3, wherein switches (224; 420) are each coupled with a control terminal (150) of one of said transistors (Ti) and are controlled by the second signals (S2i).

5. Method or circuit according to claim 4, wherein first conduction terminals (130) of the transistors (Ti) are together coupled with the switches (224; 420) by a first diode (180).

6. Method or circuit according to claim 5, wherein the first diode (180) is a Zener diode.

7. Method or circuit according to claim 5 or 6, wherein the first diode (180) is electrically in series with a second diode (222).

8. Method or circuit according to any of claims 5 to 7, wherein said switches (224) couple the first diode (180) with respective control terminals (150) of said transistors.

9. Method or circuit according to any of claims 5 to 7, wherein, for each of said transistors (Ti), said switch (420) couples the control terminal (150) with a second conduction terminal (216) of the transistor, and is coupled with the first diode (180) through a resistive element (410).

10. Method or circuit according to any of claims 5 to 9, wherein each of said switches (224) is electrically in parallel with an additional diode (310), preferably a Zener diode.

11. Method or circuit according to any of claims 5 to 10, wherein additional switches (214) are controlled by the first signal (S1) and are each coupled with one of the control terminals (150) of said transistors (Ti).

12. Device configured to implement a method according to any one of claims 1 and 3 to 11, or comprising a circuit according to any one of claims 2 to 11.

13. Device according to claim 12, wherein said transistors (Ti) are electrically in parallel between a node (130) for applying a power supply potential (VCC) and an inductive element (110).
